# EUROPEAN PATENT APPLICATION

(11) **EP 4 672 287 A2**
(43) Date of publication of application: **31.12.2025**
(21) Application number: 25173920.7
(22) Date of filing: 02.05.2025
(51) Int. Cl.: H01G 4/005, H01G 4/06, H01G 4/12, H01G 4/008, H01G 4/33, H01G 4/012, H10B 12/00, H10D 1/68, H01G 4/40

(54) **CAPACITORS WITH AMORPHOUS OXIDE LAYER FOR HIGH CAPACITANCE AND LOW LEAKAGE**

(30) Priority: 24.06.2024 US 202418751424
(71) Applicant: INTEL Corporation, Santa Clara, CA 95054 (US)
(72) Inventor: Tung, I-Cheng, Hillsboro, 97124 (US); Lin, Chia-Ching, Portland, 97229 (US); Metz, Matthew V., Portland, 97229 (US); Granados Alpizar, Bernal, Beaverton, 97007 (US); Pearce, Ryan, Beaverton, 97007 (US); Avci, Uygar E., Portland, 97225 (US); Naskar, Sudipto, Portland, 97229 (US); Atanasov, Sarah, Beaverton, 97003 (US); Chang, Sou-Chi, Portland, 97229 (US); Chen, Jiun-Ruey, Hillsboro, 97124 (US); Kim, Haydee, Hillsboro, 97124 (US); Gade, Harshal, Beaverton, 97006 (US)
(74) Representative: Goddar, Heinz J.

(57) **Abstract**

Capacitors that include an amorphous insulator layer can provide high capacitance density and low leakage. A capacitor may include two metal plates, a crystalline insulator material between the metal plates, and a thin layer of an amorphous insulator within the crystalline layer. The crystalline insulator material may be crystalline titanium dioxide, such as rutile, or a dielectric perovskite oxide, such as strontium titanium oxide or barium titanium oxide. The amorphous layer may be an amorphous oxide, such as amorphous titanium oxide, or a different oxide from the crystalline layer. The amorphous oxide layer may be sandwiched between two layers of the crystalline insulator. Alternatively, the amorphous oxide layer may be adjacent to one of the metal plates. The capacitors may be used in decoupling capacitors, memory, or for other applications.

## Description

### Background

A decoupling capacitor is a capacitor used to decouple one part of an electrical network from another, and it can be used as a local energy reservoir. Capacitors need time to charge and discharge, which opposes quick changes in voltage. Noise caused by other circuit elements can be shunted through the decoupling capacitor, reducing the effect the noise has on the rest of the circuit. When a decoupling capacitor is placed in a semiconductor package close to a power consuming circuit, it allows a direct current (DC) signal to pass through the circuit smoothly, filtering out voltage variation. The stored charge either dissipates or can be used as a local power supply to device inputs during signal switching stages.

Capacitors are created by sandwiching a dielectric material between two conductors, e.g., two metal plates. Capacitors can be designed to have larger capacitance by increasing the size of the capacitor, e.g., the area of the metal plates, or by selecting a dielectric with a higher permittivity. For decoupling capacitors and other use cases, such as memory cells, it is desirable to have a higher capacitance.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 is a cross-section across a first embodiment of a planar capacitor with crystalline and amorphous insulator layers, according to some embodiments of the present disclosure.
FIG. 2 is a cross-section across a second embodiment of a planar capacitor with crystalline and amorphous insulator layers, according to some embodiments of the present disclosure.
FIG. 3 is a cross-section of an example decoupling capacitor with crystalline and amorphous insulator layers, according to some embodiments of the present disclosure.
FIG. 4 is a circuit diagram of a memory cell, according to some embodiments of the present disclosure.
FIG. 5 is a cross-section of an example memory cell with a transistor and a capacitor, according to some embodiments of the present disclosure.
FIGS. 6A and 6B are top views of a wafer and dies that include one or more capacitors with crystalline and amorphous insulator layers in accordance with any of the embodiments disclosed herein.
FIG. 7 is a cross-sectional side view of an IC device that may include one or more capacitors with crystalline and amorphous insulator layers in accordance with any of the embodiments disclosed herein.
FIG. 8 is a cross-sectional side view of an IC device assembly that may include one or more capacitors with crystalline and amorphous insulator layers in accordance with any of the embodiments disclosed herein.
FIG. 9 is a block diagram of an example computing device that may include one or more capacitors with crystalline and amorphous insulator layers in accordance with any of the embodiments disclosed herein.

### Detailed Description

### Overview

The systems, methods and devices of this disclosure each have several innovative aspects, no single one of which is solely responsible for all desirable attributes disclosed herein. Details of one or more implementations of the subject matter described in this specification are set forth in the description below and the accompanying drawings.

Capacitors with high capacitance density and low leakage are described herein. In some embodiments, a capacitor includes two metal plates, a crystalline insulator material between the metal plates, and a thin layer of an amorphous insulator within the crystalline layer. The crystalline insulator material may be, in some examples, titanium dioxide in the form of rutile. In other embodiments, the crystalline insulator includes a perovskite oxide, such as strontium titanium oxide or barium titanium oxide. The amorphous layer may be an amorphous oxide, such as amorphous titanium oxide. The amorphous layer may be the same oxide as the crystalline layer but in a different form, or the amorphous layer may include a different oxide. The amorphous oxide layer may be sandwiched between two layers of the crystalline insulator. Alternatively, the amorphous oxide layer may be adjacent to one of the metal plates. The capacitors described herein may be used in different applications, such as decoupling capacitors or in memory.

Rutile is an oxide mineral that includes titanium dioxide (TiO₂) and can be distinguished from other structures of titanium dioxide, such as anatase, akaogiite, and brookite. Rutile is generally more stable than other forms of titanium dioxide. Rutile has a tetragonal crystal structure and a high dielectric constant. Rutile has a dielectric constant that is significantly higher than other insulators typically used in capacitors. For example, highly crystalline rutile TiO₂ has a dielectric constant that is at least twice that of hafnium zirconium-based oxides. Capacitance is proportional to dielectric constant, so capacitors that include a higher-k insulator have higher capacitances and higher capacitance density, e.g., enabling capacitors at smaller form factors to obtain a desired amount of capacitance.

Perovskite materials have a wide variety of applications in the modern electronic industry. Different perovskite materials have different material properties, e.g., with different structures and different levels of conductance. Some perovskite materials are conductors, some are semiconductors, and some are insulators. As described herein, in some embodiments, high-k perovskite materials are used in the insulator portion of a capacitor. Perovskites generally have a chemical formula ABX₃, where A and B are ions, and X is an ion that bonds to both A and B. X is often oxygen (O), forming a perovskite oxide, so the chemical formula may be written ABO₃, where A and B are ions that bond to oxygen. An idealized form of the perovskite structure is cubic, and perovskite materials often have a cubic or near-cubic crystal structure. Materials such as SrTiO₃, BaSrTiO₃, and LaAlO₃ are some examples of perovskites that have dielectric constants that are substantially greater than oxides of other metals such as hafnium or zirconium. These materials perform well as capacitor dielectrics. To obtain a perovskite material with a high dielectric constant, it is important for the perovskite material to be crystalline, and to stable at high temperatures (e.g., to withstand device fabrication). Like rutile, certain high-k perovskite materials with high dielectric constants are suitable for capacitors with smaller form factors and/or higher capacitance than capacitors with traditional dielectric materials.

In high-k oxides, including rutile and the high-k perovskite oxides described above, the dielectric constant is typically inversely related to the bandgap, with high-k materials having small energy gaps. This can result in a relatively large leakage current through the high-k oxide, which is undesirable. As described herein, adding a thin layer of an amorphous oxide to the insulator region of a capacitor can reduce leakage. For example, including an amorphous layer "breaks" the continuous crystal structure of the insulator, blocking leakage pathways within the oxide insulator. The amorphous oxide layer includes oxygen and may further include one or more of hafnium, zirconium, titanium, strontium, and barium.

The metal plates may include suitable metals for a capacitor. In some embodiments, one or both metal plates are suitable template materials for forming the crystalline insulator layers. For example, one or both metal plates may include ruthenium, ruthenium oxide, iridium oxide, titanium nitride, molybdenum oxide, rhenium, tungsten, or molybdenum. In some embodiments, a template layer is further included between a metal plate and a lower crystalline insulator layer. In some embodiments, the layers are deposited sequentially, e.g., the first crystalline insulator layer over a first metal plate, followed by the amorphous layer, followed by the second crystalline insulator layer, followed by the second metal plate. In other embodiments, one or more layers are grown separately and layer transferred over other layers of the capacitor. For example, the first crystalline insulator may be grown over the first metal plate, followed by the amorphous layer. The second crystalline insulator may be grown separately and layer-transferred over the amorphous layer.

In some embodiments, the capacitors described herein are used as decoupling capacitors. For example, a decoupling capacitor may be a large capacitor that includes an electrode that extends across and into a series of openings. For example, an array of openings is formed across a support structure, and a single capacitor is formed over the support structure, with the electrodes extending into the openings. For example, if an IC package includes a decoupling capacitor, the decoupling capacitor may extend across an area that is 80% or 90% of the area of the IC package.

In some embodiments, the capacitors described herein are used in memory cells. A memory cell may include a capacitor for storing a bit value or a memory state (e.g., logical "1" or "0") of the cell, and an access transistor controlling access to the cell (e.g., access to write information to the cell or access to read information from the cell). Such a memory cell may be referred to as a "1T-1C memory cell," highlighting the fact that it uses one transistor (i.e., "1T" in the term "1T-1C memory cell") and one capacitor (i.e., "1C" in the term "1T-1C memory cell"). The capacitor of a 1T-1C memory cell may be coupled to one source or drain (S/D) region/terminal of the access transistor (e.g., to the source region of the access transistor) by a first S/D contact, while the other S/D region of the access transistor may be coupled to a bitline (BL) by a second S/D contact, and a gate terminal of the transistor may be coupled to a word-line (WL) by a gate contact. Various 1T-1C memory cells have, conventionally, been implemented with access transistors being front end of line (FEOL), logic-process based, transistors implemented in an upper-most layer of a semiconductor substrate.

The BL and WL are each formed from metal interconnects that are coupled to additional memory cells, and in particular, access transistors of other memory cells. For example, a BL runs along a column of memory cells, and the BL is coupled to one S/D terminal of each of the access transistors in the column of memory cells via an S/D contact. A WL runs along a row of memory cells, and the WL is coupled to the gate of each of the access transistors in the row of memory cells via a gate contact.

The capacitors with crystalline and amorphous insulator layers described herein may be implemented in, or in combination with, more components associated with an IC or/and between various such components. In various embodiments, components associated with an IC include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. The IC may be employed as part of a chipset for executing one or more related functions in a computer.

For purposes of explanation, specific numbers, materials and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well known features are omitted or simplified in order not to obscure the illustrative implementations.

In the following detailed description, reference is made to the accompanying drawings that form a part hereof, and in which is shown, by way of illustration, embodiments that may be practiced. It is to be understood that other embodiments may be utilized and structural or logical changes may be made without departing from the scope of the present disclosure. Therefore, the following detailed description is not to be taken in a limiting sense.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges. The meaning of "a," "an," and "the" include plural references. The meaning of "in" includes "in" and "on."

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. The terms "substantially," "close," "approximately," "near," and "about," generally refer to being within +/- 20% of a target value, unless specified otherwise. Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, various aspects of the illustrative implementations will be described using terms commonly employed by those skilled in the art to convey the substance of their work to others skilled in the art. For example, as used herein, a "READ" and "WRITE" memory access or operations refer to, respectively, determining/sensing a logic state of a memory cell and programming/setting a logic state of a memory cell. In other examples, the term "connected" means a direct electrical or magnetic connection between the things that are connected, without any intermediary devices, while the term "coupled" means either a direct electrical or magnetic connection between the things that are connected or an indirect connection through one or more passive or active intermediary devices. The term "circuit" means one or more passive and/or active components that are arranged to cooperate with one another to provide a desired function. In yet another example, a "high-k dielectric" refers to a material having a higher dielectric constant (k) than silicon oxide. The terms "oxide," "carbide," "nitride," etc. refer to compounds containing, respectively, oxygen, carbon, nitrogen, etc.

### Example Planar Capacitors With Crystalline and Amorphous Insulator Layers

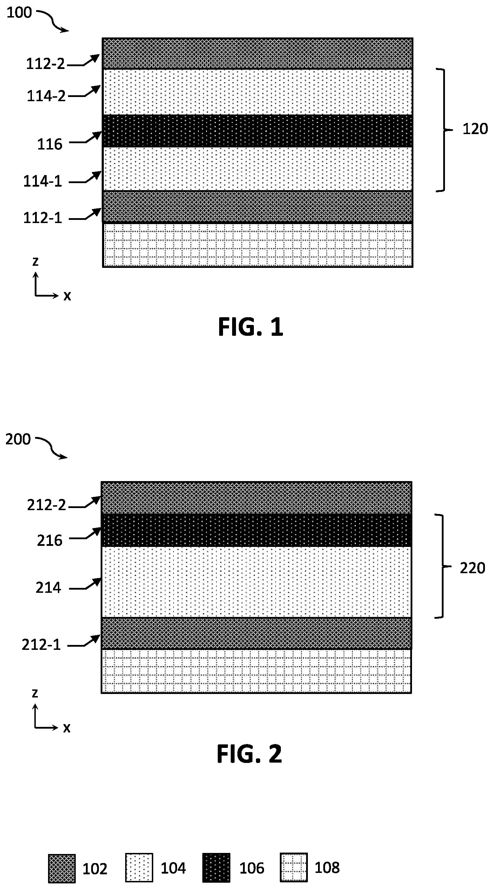

FIG. 1 is a cross-sectional view showing an example arrangement of a planar capacitor 100 having crystalline and amorphous insulator layers, according to some embodiments of the present disclosure.

A number of elements referred to in the description of FIGs. 1-5 with reference numerals are illustrated in these figures with different patterns, with a legend showing the correspondence between the reference numerals and patterns being provided at the bottom or side of each drawing page containing FIGs. 1-5. For example, the legend under FIGs. 1 and 2 illustrates that these figures use different patterns to show an electrode material 102, a crystalline insulator 104, and an amorphous insulator 106.

In the drawings, some example structures of various devices and assemblies described herein are shown with precise right angles and straight lines, but it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication.

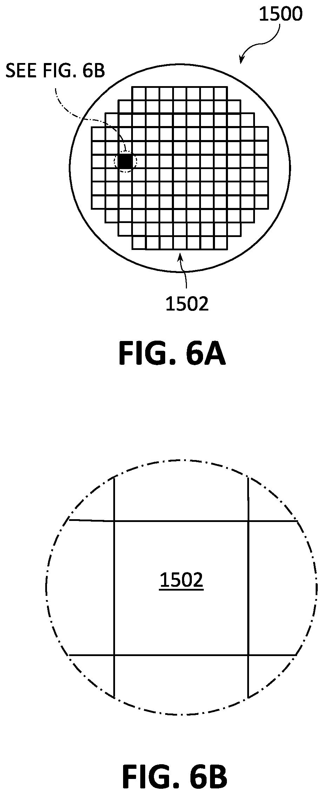

In general, implementations of the present disclosure may be formed or carried out on a support structure 108. The support structure 108 may be, e.g., a substrate, a die, a wafer or a chip. For example, the support structure may be the wafer 1500 of FIG. 6A, discussed below, and may be, or be included in, a die, e.g., the singulated die 1502 of FIG. 6B, discussed below. The support structure 108 extends along the x-y plane in the coordinate system shown in FIG. 1. In some embodiments, a support structure 108 may be used during a fabrication process and later removed.

In some embodiments, the support structure 108 may be a substrate that includes silicon and/or hafnium. More generally, the support structure may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. In some embodiments, the support structure may be a printed circuit board (PCB) substrate. Although a few examples of materials from which the substrate may be formed are described here, any material that may serve as a foundation upon which a semiconductor device including one or more nanoribbon transistors, as described herein, may be built falls within the spirit and scope of the present disclosure.

The capacitor 100 is formed over the support structure 108. The capacitor 100 includes a first electrode 112-1 over the support structure 108, a first crystalline insulator layer 114-1 over the first electrode 112-1, an amorphous layer 116 over the first crystalline insulator layer 114-1, a second crystalline insulator layer 114-2 over the amorphous layer 116, and a second electrode 112-2 over the second crystalline insulator layer 114-2. The first electrode 112-1 may be considered a bottom electrode, and the second electrode 112-2 may be considered a top electrode. Electrical contacts (not shown in FIG. 1) may be coupled to each of the first electrode 112-1 and second electrode 112-2 to apply a voltage across the capacitor 100. The first crystalline insulator layer 114-1, amorphous layer 116, and second crystalline insulator layer 114-2 form an insulator region 120 between the two electrodes 112-1 and 112-2.

The first electrode 112-1 and the second electrode 112-2 (referred to jointly as electrodes 112, or as a pair of electrodes 112) are formed of an electrode material 102. In some embodiments, the electrode material 102 is or includes ruthenium. For example, the electrode material 102 may include ruthenium and oxygen in the form of ruthenium oxide. In some embodiments, the electrode material 102 includes iridium, e.g., the electrode material is iridium oxide (IrO₂). In some embodiments, the electrode material 102 includes titanium nitride (TiN). In some embodiments, the electrode material 102 includes rhenium, tungsten, or molybdenum, e.g., molybdenum oxide (MoO₂). While the first electrode 112-1 and second electrode 112-2 are depicted as being formed from the same electrode material 102 (e.g., both the first electrode 112-1 and second electrode 112-2 are ruthenium), in other embodiments, the first electrode 112-1 and second electrode 112-2 may be formed from different materials. The electrodes 112 may each have a thickness between, e.g., 2.5 nm and 30 nm. In some embodiments, the electrodes 112 may have a thickness of at least 10 nm, e.g., between 10 nm and 20 nm.

The first crystalline insulator layer 114-1 and the second crystalline insulator layer 114-2 (referred to jointly as crystalline insulator layers 114) are formed of a crystalline insulator 104. In some embodiments, the crystalline insulator 104 includes titanium and oxygen, e.g., the crystalline insulator 104 is TiO₂. For example, the crystalline insulator 104 may be rutile; as described above, rutile has a tetragonal crystal structure and a high dielectric constant.

In some embodiments, the crystalline insulator 104 includes a high-k perovskite material, such as a high-k perovskite oxide. As noted above, perovskite oxides generally have a chemical formula ABO₃, where A and B are ions, and O is oxygen, which bonds to both A and B. An idealized form of the perovskite structure is cubic, and perovskite materials often have a cubic or near-cubic crystal structure. In addition to oxygen, insulating perovskite oxides may include strontium (e.g., SrTiO₃), barium and strontium (e.g., BaSrTiO₃), or lanthanum and aluminum (e.g., LaAlO₃). Other materials with a perovskite crystal structure with high dielectric constants may be used as the crystalline insulator 104.

While the first crystalline insulator layer 114-1 and second crystalline insulator layer 114-2 are depicted as being formed from the same crystalline insulator 104 (e.g., both the first crystalline insulator layer 114-1 and second crystalline insulator layer 114-2 are rutile), in other embodiments, the first crystalline insulator layer 114-1 and second crystalline insulator layer 114-2 may be formed from different materials. One or both of the crystalline insulator layers 114 may have a thickness (measured in the z-direction) of less than 15 nm, e.g., each may have a thickness between 2 nm and 10 nm. While the first crystalline insulator layer 114-1 and second crystalline insulator layer 114-2 are illustrated as having a same or similar thickness, in other embodiments, the first crystalline insulator layer 114-1 may be thicker than the second crystalline insulator layer 114-2 (e.g., the first crystalline insulator layer 114-1 has a thickness of 12 nm and the second crystalline insulator layer 114-2 has a thickness of 4 nm, or the first crystalline insulator layer 114-1 has a thickness of 8 nm and the second crystalline insulator layer 114-2 has a thickness of 6 nm), or vice versa.

The amorphous layer 116 that includes the amorphous insulator 106 is between the first crystalline insulator layer 114-1 and second crystalline insulator layer 114-2. As discussed above, the amorphous layer may reduce leakage across the capacitor 100, e.g., by blocking leakage pathways within the capacitor 100. The amorphous insulator 106 may be an oxide that includes oxygen. The amorphous insulator 106 may further include one or more of hafnium (e.g., HfO₂), zirconium (e.g., ZrO₂), titanium (e.g., TiO₂), strontium (e.g., SrTiO₃), barium (e.g., BaTiO₃ or SrₓBa₁₋ₓTiO₃), or lanthanum and aluminum (e.g., amorphous LaAlO₃). In some embodiments, the amorphous insulator 106 includes the same elements as the crystalline insulator 104 but in a different configuration, e.g., the crystalline insulator 104 is rutile, and the amorphous insulator 106 is amorphous titanium dioxide. In other embodiments, the amorphous insulator 106 includes one or more different elements from the crystalline insulator 104, or vice versa.

The amorphous layer 116 may be relatively thin; for example, the amorphous layer 116 may have a thickness (measured in the z-direction, and equal to a distance between the first crystalline insulator layer 114-1 and second crystalline insulator layer 114-2) of less than 5 nm, e.g., between 1 and 5 nm. The insulator region 120 of the capacitor 100 may have an overall thickness (measured in the z-direction, and equal to a distance between the first electrode 112-1 and second electrode 112-2) of less than 20 nm, e.g., between 5 nm and 20 nm, between 10 nm and 20 nm, or within some other range.

In some embodiments, one or more template layers, not illustrated in FIG. 1, are included in the capacitor 100. For example, a template layer having the desired crystal structure of the crystalline insulator 104 may be included under the first crystalline insulator layer 114-1 and/or the second crystalline insulator layer 114-2 and serve as a suitable base for depositing the crystalline insulator 104 with the desired crystal structure. A template layer may have a thickness between, e.g., 1 and 4 nm. The template layer(s) may have a negligible effect on the electrical properties of the capacitor 100.

For example, a template layer may be between the first electrode 112-1 and the first crystalline insulator layer 114-1. The template layer may be grown over the first electrode 112-1 using epitaxial deposition, or the template layer may be layer-transferred onto the first electrode 112-1. The template layer may include a templating material. In some embodiments, the templating material has a structure similar to rutile. In some embodiments, the templating material is a perovskite, e.g., a perovskite oxide that includes oxygen, strontium, and at least one additional metal. The additional metal may be, for example, titanium, ruthenium, scandium, rhodium, hafnium, barium, chromium, or iron. In some embodiments, the templating material may include a second additional metal material selected from titanium, ruthenium, scandium, rhodium, hafnium, barium, chromium, or iron. The templating material may have a chemical formula SrₓB_{y}O_{3-z}, where B represents the additional metal (e.g., one of titanium, ruthenium, scandium, rhodium, hafnium, barium, chromium, or iron), x is between 0.1 and 1, y is between 0.1 and 1, and z is between 0 and 2.9. In embodiments that include two additional metals (e.g., two of titanium, ruthenium, scandium, rhodium, hafnium, barium, chromium, and iron), the templating material may have a chemical formula Srₓ(BB')_{y}O_{3-z}, where B is the first additional metal, B' is the second additional metal, x is between 0.1 and 1, y is between 0.1 and 1, and z is between 0 and 2.9. As one example, B may be ruthenium, and B' may be titanium.

Forming first crystalline insulator layer 114-1 over the template layer, rather than directly over the first electrode 112-1, may improve the crystal structure of the first crystalline insulator layer 114-1, increasing the dielectric constant of the first crystalline insulator layer 114-1 and improving performance of the capacitor 100. For example, the material for the template layer may be selected so that the template layer and the first crystalline insulator layer 114-1 have crystal structures with similar lattice parameters, e.g., within 0.5 Å of each other, or within a smaller range of each other (e.g., within 0.3 Å or 0.1 Å). More generally, when a first layer of a first crystalline material is epitaxially deposited over a second layer of a second crystalline material, it is beneficial for the first crystalline material to have a similar structure to the second crystalline material. The similarity of structure helps the first crystalline material form the proper crystal structure when deposited over the second crystalline material. The growing of a first crystalline material over a different, second crystalline material is referred to as heteroepitaxial growth.

In some embodiments, another template layer is included between the amorphous layer 116 and the second crystalline insulator layer 114-2. This template layer may improve deposition of the second crystalline insulator layer 114-2 in a similar manner to the template layer under the first crystalline insulator layer 114-1. In some embodiments, a template layer may be included between the second crystalline insulator layer 114-2 and the second electrode 112-2. In such embodiments, the first electrode 112-1, first crystalline insulator layer 114-1, and amorphous layer 116 may have been formed as a first stack, while the second crystalline insulator layer 114-2 may have been deposited over the second electrode 112-2 and the template layer, forming a second stack. The second stack may then have been layer transferred over the first stack, forming the capacitor 100. For example, the second stack is attached to or formed over a carrier wafer, a surface of the second crystalline insulator layer 114-2 is bonded to the top surface of the first stack (e.g., an upper surface of the amorphous layer 116), and the carrier wafer is removed from the second stack. In some embodiments, a similar layer transfer process may be formed without use of the template layers, e.g., if the first electrode 112-1 and second electrode 112-2 are suitable templates for depositing the crystalline insulator 104.

In some embodiments, a seed layer (not specifically shown in FIG. 1) may be included between the support structure 108 and the first electrode 112-1. The seed layer may be included in addition to or instead of the template layer discussed above. A seed layer may improve the structure of the electrode material 102 in the first electrode 112-1. In particular, growing the first electrode 112-1 (e.g., a ruthenium or indium gate electrode) over a seed layer may reduce surface roughness of the upper surface of the first electrode 112-1, which can improve crystallinity of the template layer (if included) and/or the crystallinity of the first crystalline insulator layer 114-1 formed over the first electrode 112-1. Likewise, a seed layer may be included above the second electrode 112-2, e.g., if the second crystalline insulator layer 114-2 is grown over the 112-2 and layer-transferred onto the stack of the first electrode 112-1, first crystalline insulator layer 114-1, and amorphous layer 116, as described above.

The seed layer may include, first example, a crystalline tantalum. In an embodiment, the tantalum seed layer has an amorphous structure. A tantalum seed layer may be advantageously chosen for its high melting point, such as greater than 1500 degrees C. A further advantage includes ease of patterning a seed layer including tantalum compared to other refractory metals, such as titanium or tungsten, that have similar melting points.

If a layer transfer process is used, the first crystalline insulator layer 114-1 and second crystalline insulator layer 114-2 may include crystals of similar sizes, e.g., they may both be highly monocrystalline. If a layer transfer process is not used, and the second crystalline insulator layer 114-2 is deposited over the amorphous layer 116, the crystallinity of the second crystalline insulator layer 114-2 may be inferior to the crystallinity of the first crystalline insulator layer 114-1. For example, in such cases, the crystalline insulator 104 in the second crystalline insulator layer 114-2 may have a smaller grain size (e.g., a smaller average grain size, a smaller minimum grain size) than the crystalline insulator 104 in the first crystalline insulator layer 114-1, or the crystalline insulator 104 in the second crystalline insulator layer 114-2 may have a greater defect density than the crystalline insulator 104 in the first crystalline insulator layer 114-1.

FIG. 2 is a cross-section across a second embodiment of a planar capacitor with crystalline and amorphous insulator layers, according to some embodiments of the present disclosure. FIG. 2 illustrates a capacitor 200 formed over a support structure 108, which may be similar to the support structure described with respect to FIG. 1. The capacitor 200 includes a first electrode 212-1 over the support structure 108, a crystalline insulator layer 214 over the first electrode 212-1, an amorphous layer 216 over the first electrode 112-1, and a second electrode 212-2 over the amorphous layer 216. The capacitor 200 does not include a second crystalline insulator layer (e.g., similar to the second crystalline insulator layer 114-2 of FIG. 1) between the amorphous layer 216 and the second electrode 212-2. In other embodiments, the capacitor 200 may be flipped, with the crystalline insulator layer 214 may be between the amorphous layer 216 and the second electrode 212-2.

The first electrode 212-1 may be considered a bottom electrode, and the second electrode 212-2 may be considered a top electrode. Electrical contacts (not shown in FIG. 2) may be coupled to each of the first electrode 212-1 and second electrode 212-2 to apply a voltage across the capacitor 200. The crystalline insulator layer 214 and amorphous layer 216 form an insulator region 220 between the pair of electrodes 212.

The pair of electrodes 212 may be similar to the pair of electrodes 112 of FIG. 1. The crystalline insulator layer 214 is similar to the first crystalline insulator layer 114-1 of FIG. 1. The amorphous layer 216 is similar to the amorphous layer 116 of FIG. 1. In some embodiments, the crystalline insulator layer 214 may be thicker than the first crystalline insulator layer 114-1 of FIG. 1. For example, the insulator region 220 may have a total thickness (e.g., a distance between the two electrodes 212) of 20 nm or less, and the crystalline insulator layer 214 may have a total thickness of, e.g., 18 nm or less. The capacitor 200 may include one or more template layers and/or seed layers, as described with respect to FIG. 1

### Example Non-Planar Decoupling Capacitor With Crystalline and Amorphous Insulator Layers

FIGs. 1 and 2 depicted planar transistors, where each of the layers extended substantially in the x- and y-directions, and the layers were arranged in parallel planes. Planar capacitors such as those described above can be used as decoupling capacitors, for DRAM arrays, and for other applications.

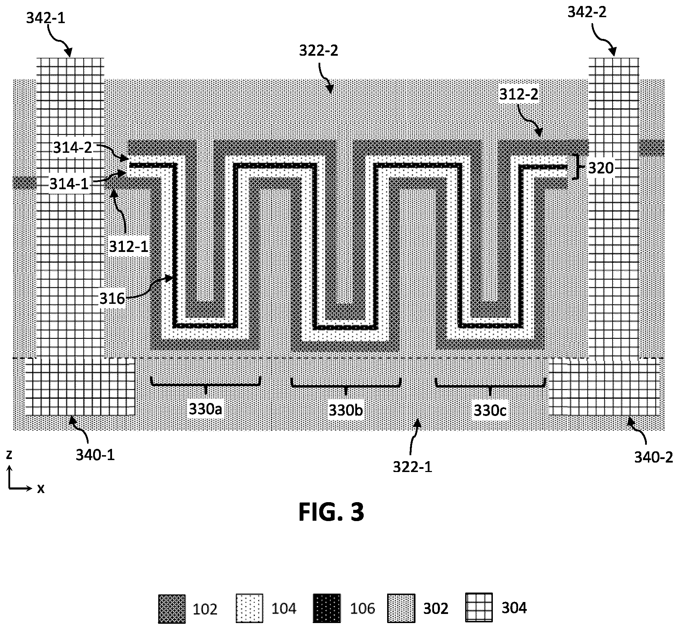

Increasing the surface area of a transistor (e.g., surface area of the electrodes) increases capacitance. Therefore, for high-capacitance applications, it can be beneficial to have a three-dimensional capacitor architecture rather than a planar capacitor. FIG. 3 is a cross-section of an example three-dimensional capacitor with crystalline and amorphous insulator layers, according to some embodiments of the present disclosure. The capacitor 300 of FIG. 3 may be used as a decoupling capacitor.

To form three-dimensional capacitors, one or more openings are formed in a dielectric material 302. The dielectric material 302 may be formed over a support structure 108, as depicted, or the dielectric material 302 may be the support structure itself. The openings extend partway through the dielectric material 302, with the dielectric material 302 forming sidewalls and the base of the openings. The dielectric material 302 with the openings therein forms a first dielectric region 322-1.

A first electrode layer 312-1 is deposited over the dielectric material 302, including in the openings formed therein and along the top face of the dielectric material 302. The first electrode layer 312-1 includes the electrode material 102 described above.

An insulator region 320 is deposited over the first electrode layer 312-1, extending into the openings and along a top face of the first electrode layer 312-1. The insulator region 320 includes a first crystalline insulator layer 314-1, an amorphous layer 316, and a second crystalline insulator layer 314-2. The insulator region 320 and its component layers are generally similar to the insulator region 120 and include the crystalline insulator 104 and amorphous insulator 106 described above. However, unlike the insulator region 120, the layers of the insulator region 320 are not planar, but instead conform to the shape of the dielectric region 322-1. In other embodiments, the insulator region 320 may include a single layer of the crystalline insulator 104, as described with respect to FIG. 2.

A second electrode layer 312-2 is deposited over the insulator region 320. The second electrode layer 312-2 includes the electrode material 102 described above. The capacitor 300 may include one or more template layers and/or seed layers, as described with respect to FIG. 1. Each of the layers 312, 314, and 316 may have thicknesses similar to the thicknesses of the layers 112, 114, and 116, respectively, as described with respect to FIG. 1.

A second dielectric region 322-2 of the dielectric material 302 is formed over the second electrode layer 312-2. In this example, after deposition of the second electrode layer 312-2, the openings are not filled in by the electrode material 102, crystalline insulator 104, and amorphous insulator 106. Thus, the dielectric material 302 in the second dielectric region 322-2 extends into the openings. In other embodiments, the second electrode layer 312-2 may fill the openings, so the second dielectric region 322-2 has a flat or substantially flat lower surface, rather than extending into the openings.

The openings, when filled with the electrode material 102, crystalline insulator 104, and amorphous insulator 106, form the portions 330a, 330b, and 330c of the capacitor 300. The portions 330 may be referred to as via portions of the capacitor 300, while portions of the capacitor 300 that extend over an upper surface of the first dielectric region 322-1 (e.g., in the x and y directions in the coordinate system shown) may be referred to as planar portions of the capacitor 300.

FIG. 3 further illustrates two electrode contacts 342-1 and 342-2 that electrically couple the electrode layers 312 to interconnect structures 340-1 and 340-2. In particular, a first electrode contact 342-1 couples the first electrode layer 312-1 to the first interconnect structure 340-1, and a second electrode contact 342-2 couples the second electrode layer 312-2 to the second interconnect structure 340-2. The first electrode contact 342-1 is in contact with the planar portion of the first electrode layer 312-1, and the second electrode contact 342-2 is in contact with the planar portion of the second electrode layer 312-2. The contacts 342 may apply a voltage difference to the capacitor electrodes 312 based on voltage settings transferred through the interconnect structures 340. The electrode contacts 342 and interconnect structures 340 are formed of an electrically conductive material 304.

While three via portions 330 are shown in FIG. 3, capacitors can be formed by a pair of electrodes that extend across and into many openings. For example, an array of openings is formed across a support structure, and a single capacitor is formed over the support structure, with the electrodes and insulator region extending into the openings. A capacitor formed across a large portion of the substrate can be used as a decoupling capacitor. For example, if an IC package includes a decoupling capacitor, the decoupling capacitor may extend across an area that is 80% or 90% of the area of the IC package.

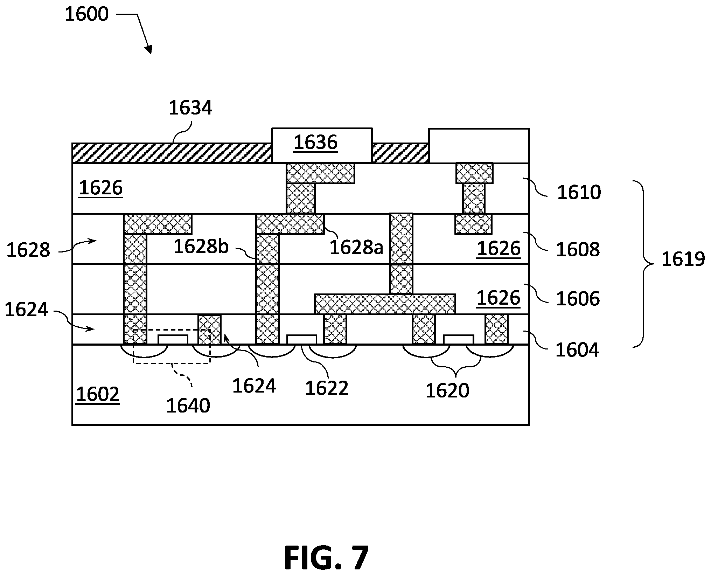

In some embodiments, the capacitor 300 is on the back side of a device. For example, an IC device including the capacitor 300 may have a transistor layer or device layer (as discussed with respect to FIG. 7) and a front side metallization stack, such as the interconnect layers shown in FIG. 7, formed over the transistor layer (i.e., on a front side of the IC device). The capacitor 300 may be formed in one or more backside layers of the IC device, i.e., layers on a side of the IC device layer opposite the front side, where the front side metallization stack is formed. The process for fabricating the capacitor 300 may be compatible with backside processing parameters, such as temperature.

### Example Memory Device With Capacitor With Crystalline and Amorphous Insulator Layers

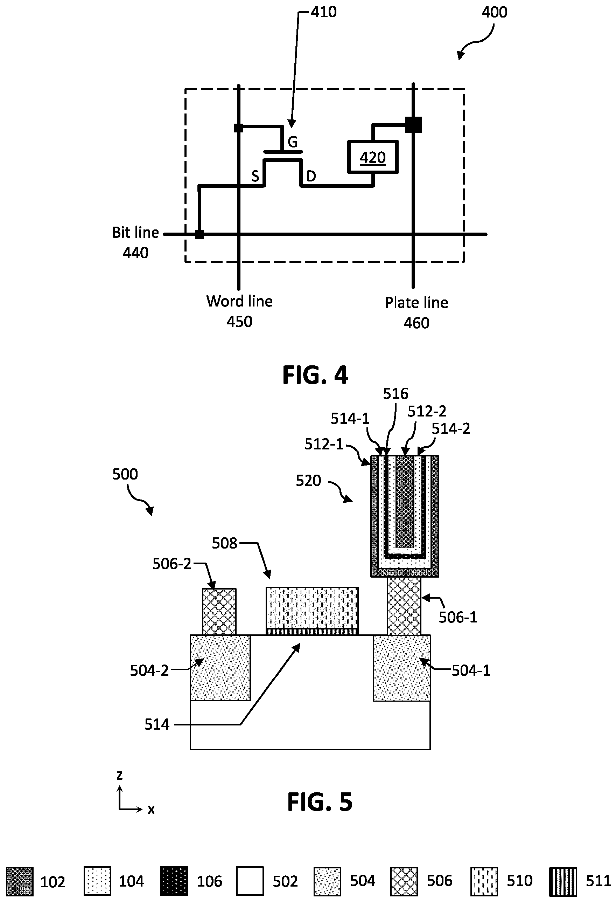

FIG. 4 is a circuit diagram of a memory cell, according to some embodiments of the present disclosure. In particular, FIG. 4 is an electrical circuit diagram of an example 1T-1C memory cell 400. As shown, the 1T-1C cell 400 may include an access transistor 410 and a capacitor 420. The access transistor 410 has a gate terminal, a source terminal, and a drain terminal, indicated in the example of FIG. 4 as terminals G, S, and D, respectively. In the following, the terms "terminal" and "electrode" may be used interchangeably. Furthermore, for S/D terminals, the terms "terminal" and "region" may be used interchangeably.

As shown in FIG. 4, in the 1T-1C cell 400, the gate terminal of the access transistor 410 may be coupled to a word line (WL) 450, one of the S/D terminals of the access transistor 410 may be coupled to a bit line (BL) 440, and the other one of the S/D terminals of the access transistor 410 may be coupled to a first electrode of the capacitor 420. As also shown in FIG. 4, the other electrode of the capacitor 420 may be coupled to a capacitor plate line (PL) 460. As is known in the art, WL, BL, and PL may be used together to read and program the capacitor 420.

Each of the BL 440, the WL 450, and the PL 460, as well as intermediate elements coupling these lines to various terminals described herein, may be formed of any suitable electrically conductive material, which may include an alloy or a stack of multiple electrically conductive materials. In some embodiments, such electrically conductive materials may include one or more metals or metal alloys, with metals such as ruthenium, palladium, platinum, cobalt, nickel, hafnium, zirconium, titanium, tantalum, and aluminum. In some embodiments, such electrically conductive materials may include one or more electrically conductive alloys oxides or carbides of one or more metals.

FIG. 5 is a cross-section of an example memory cell with a transistor and a capacitor, according to some embodiments of the present disclosure. FIG. 5 illustrates how a transistor (e.g., the transistor 410) and a capacitor (e.g., the capacitor 420) may be used to form a 1T-1C memory cell. In general, a field-effect transistor (FET), e.g., a metal oxide semiconductor (MOS) FET (MOSFET), is a three-terminal device that includes source, drain, and gate terminals and uses electric field to control current flowing through the device. A FET typically includes a channel material, a source region and a drain region provided in the channel material, and a gate stack that includes a gate electrode material, alternatively referred to as a "work function" material, provided over a portion of the channel material between the source and the drain regions, and, optionally, also includes a gate dielectric material between the gate electrode material and the channel material. This general structure of the transistor is shown in FIG. 5, which shows a channel material 502, S/D regions 504 (shown as a first S/D region 504-1, e.g., a source region, and a second S/D region 504-2, e.g., a drain region), contacts 506 to the S/D regions (shown as a first S/D contact 506-1, providing electrical contact to the first S/D region 504-1, and a second S/D contact 506-2, providing electrical contact to the second S/D region 504-2), and a gate stack 508, which includes at least a gate electrode 510 and may also, optionally, include a gate dielectric 511.

The channel material 502 may include a monocrystalline semiconductor, such as silicon (Si) or germanium (Ge). In some embodiments, the channel material 502 may include a compound semiconductor with a first sub-lattice of at least one element from group III of the periodic table (e.g., Al, Ga, In), and a second sub-lattice of at least one element of group V of the periodic table (e.g., P, As, Sb). For some embodiments, the channel material 502 may include a III-V material having a high electron mobility, such as, but not limited to InGaAs, InP, InSb, and InAs. For some such embodiments, the channel material 502 may be a ternary III-V alloy, such as InGaAs, GaAsSb, InAsP, or InPSb. For some InₓGa₁₋ₓAs embodiments, the In content (x) may be between 0.6 and 0.9, and may advantageously be at least 0.7 (e.g., In_{0.7}Ga_{0.3}As). For other embodiments, one or more of the semiconductor materials may be a group IV material having a high hole mobility, such as, but not limited to Ge or a Ge-rich SiGe alloy. For some example embodiments, the channel material 502 may have a Ge content between 0.6 and 0.9, and may be at least 0.7.

In some embodiments, the channel material 502 may be a thin-film material, such as a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, the channel material 502 may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphite, and black phosphorus. Suitable dopants for the channel material 502 may include gallium, indium, aluminum, fluorine, boron, phosphorus, arsenic, nitrogen, tantalum, tungsten, magnesium, etc.

As shown in FIG. 5, a first and a second S/D regions 504-1, 504-2 (together referred to as "S/D regions 504") may be included on either side of the gate stack 508, thus realizing a transistor. As is known in the art, source and drain regions (also sometimes interchangeably referred to as "diffusion regions") are formed for the gate stack of a FET. In some embodiments, the S/D regions 504 of the transistor may be regions of doped semiconductors, e.g. regions of the channel material 502 (e.g., of the channel portion 503) doped with a suitable dopant to a suitable dopant concentration, so as to supply charge carriers for the transistor channel. In some embodiments, the S/D regions 504 may be highly doped, e.g. with dopant concentrations of about 1·10²¹ cm⁻³, in order to advantageously form Ohmic contacts with the respective S/D contacts 506, although, in other embodiments, these regions may also have lower dopant concentrations and may form Schottky contacts in some implementations. Irrespective of the exact doping levels, the S/D regions 504 may be the regions having dopant concentration higher than in other regions, e.g. higher than a dopant concentration in a region of the channel material 502 between the first S/D region 504-1 and the second S/D region 504-2, and, therefore, may be referred to as "highly doped" (HD) regions. In some embodiments, the S/D regions 504 may generally be formed using either an implantation/diffusion process or an etching/deposition process. In the former process, dopants such as boron, aluminum, antimony, phosphorous, or arsenic may be ion-implanted into the one or more semiconductor materials of the upper portion of the channel material 502 to form the S/D regions 504. An annealing process that activates the dopants and causes them to diffuse further into the channel material 502 may follow the ion implantation process. In the latter process, the one or more semiconductor materials of the channel material 502 may first be etched to form recesses at the locations for the future S/D regions. An epitaxial deposition process may then be carried out to fill the recesses with material (which may include a combination of different materials) that is used to fabricate the S/D regions 504. In some implementations, the S/D regions 504 may be fabricated using a silicon alloy such as silicon germanium or silicon carbide. In some implementations, the epitaxially deposited silicon alloy may be doped in situ with dopants such as boron, arsenic, or phosphorous. In further embodiments, the S/D regions 504 may be formed using one or more alternate semiconductor materials such as germanium or a group III-V material or alloy. Although FIG. 5 illustrates the first and second S/D regions 504 with a single pattern, suggesting that the material composition of the first and second S/D regions 504 is the same, this may not be the case in some other embodiments of the transistor. Thus, in some embodiments, the material composition of the first S/D region 504-1 may be different from the material composition of the second S/D region 504-2.

As further shown in FIG. 5, S/D contacts 506-1 and 506-2 (together referred to as "S/D contacts 506"), formed of one or more electrically conductive materials, may be used for providing electrical connectivity to the S/D regions 504-1 and 504-2, respectively. In various embodiments, one or more layers of metal and/or metal alloys may be used to form the S/D contacts 506. For example, the electrically conductive materials of the S/D contacts 506 may include one or more metals or metal alloys, with materials such as copper, ruthenium, palladium, platinum, cobalt, nickel, hafnium, zirconium, titanium, tantalum, and aluminum, tantalum nitride, tungsten, doped silicon, doped germanium, or alloys and mixtures of any of these. In some embodiments, the S/D contacts 506 may include one or more electrically conductive alloys, oxides, or carbides of one or more metals. In some embodiments, the S/D contacts 506 may include a doped semiconductor, such as silicon or another semiconductor doped with an N-type dopant or a P-type dopant. Metals may provide higher conductivity, while doped semiconductors may be easier to pattern during fabrication. Although FIG. 5 illustrates the first and second S/D contacts 506 with a single pattern, suggesting that the material composition of the first and second S/D contacts 506 is the same, this may not be the case in some other embodiments of the transistor 501. Thus, in some embodiments, the material composition of the first S/D contact 506-1 may be different from the material composition of the second S/D contact 506-2.

Turning to the gate stack 508, the gate electrode 510 may include at least one P-type work function metal or N-type work function metal, depending on whether the transistor 501 is a PMOS transistor or an NMOS transistor. For a PMOS transistor, metals that may be used for the gate electrode 510 may include, but are not limited to, ruthenium, palladium, platinum, cobalt, nickel, and conductive metal oxides (e.g., ruthenium oxide). For an NMOS transistor, metals that may be used for the gate electrode 510 include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, the gate electrode 510 may include a stack of two or more metal layers, where one or more metal layers are WF metal layers and at least one metal layer is a fill metal layer. Further metal layers may be included for other purposes, such as to act as a diffusion barrier layer.

If used, the gate dielectric 511 may at least laterally surround the channel portion 503, and the gate electrode 510 may laterally surround the gate dielectric 511 such that the gate dielectric 511 is disposed between the gate electrode 510 and the channel material 502. In various embodiments, the gate dielectric 511 may include one or more high-k dielectric materials and may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric 511 may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In some embodiments, an annealing process may be carried out on the gate dielectric 511 during manufacture of the transistor to improve the quality of the gate dielectric 511. In some embodiments, the gate dielectric 511 may have a thickness between about 0.5 nanometers and 3 nanometers, including all values and ranges therein, e.g., between about 1 and 3 nanometers, or between about 1 and 2 nanometers.

In some embodiments, the gate stack 508 may be surrounded by a dielectric spacer, not specifically shown in FIG. 5. The dielectric spacer may be configured to provide separation between the gate stacks 508 of different transistors which may be provided adjacent to one another (e.g., different transistors provided along a single fin if the transistors 501 are FinFETs), as well as between the gate stack 508 and one of the S/D contacts 506 that is disposed on the same side as the gate stack 508. Such a dielectric spacer may include one or more low-k dielectric materials. Examples of the low-k dielectric materials that may be used as the dielectric spacer (or in other dielectric materials described herein) include, but are not limited to, silicon dioxide, carbon-doped oxide, silicon nitride, fused silica glass (FSG), and organosilicates such as silsesquioxane, siloxane, and organosilicate glass. Other examples of low-k dielectric materials include organic polymers such as polyimide, polynorbornenes, benzocyclobutene, perfluorocyclobutane, or polytetrafluoroethylene (PTFE). Still other examples of low-k dielectric materials that may be used as the dielectric spacer include silicon-based polymeric dielectrics such as hydrogen silsesquioxane (HSQ) and methylsilsesquioxane (MSQ). Other examples of low-k materials that may be used in a dielectric spacer include various porous dielectric materials, such as for example porous silicon dioxide or porous carbon-doped silicon dioxide, where large voids or pores are created in a dielectric in order to reduce the overall dielectric constant of the layer, since voids can have a dielectric constant of nearly 1.

In this example, both of the S/D contacts 506 are on the same side of the transistor, e.g., a front side of the transistor. The gate stack 508 is also on the front side of the transistor. In other embodiments, one or more of the S/D contacts 506, and/or the gate stack 508, are on a back side of the transistor, referred to as the back side.

Transistors, such as access transistors for memory cells, may be implemented using any suitable transistor architecture, e.g. planar or non-planar architectures. For example, an access transistor may be implemented as a FinFET or a nanoribbon transistor, as are known in the art.

The capacitor 520, which is an example of the capacitor 420, is illustrated as a three-dimensional capacitor. The capacitor 520 can store a bit value, or a memory state (e.g., logical "1" or "0") of the memory cell 500, and the transistor may then function as an access transistor controlling access to the memory cell 500 (e.g., access to write information to the cell or access to read information from the cell). By coupling the capacitor 520 to the S/D region 504-1, the capacitor 520 is configured to store the memory state of the memory cell 500. In some embodiments, the capacitor 520 may be coupled to the S/D region 504-1 via a storage node (not specifically shown in FIG. 5) coupled to the S/D region 504-1. In some embodiments, the S/D contact 506-1 may be considered to be the storage node.

The capacitor 520 includes a first electrode layer 512-1 that is over and in contact with the S/D contact 506-1. The first electrode layer 512-1 may be formed within a dielectric material, e.g., an opening within the dielectric material 302, in a similar manner to one of the via portions 330 in the first electrode layer 312-1 of FIG. 3. The first electrode layer 512-1 includes the electrode material 102 described above.

An insulator region is deposited over the first electrode layer 512-1, and nested within the first electrode layer 512-1. The insulator region includes a first crystalline insulator layer 514-1, an amorphous layer 516, and a second crystalline insulator layer 514-2. The first crystalline insulator layer 514-1 is nested within the 512-1; the amorphous layer 516 is nested within the first crystalline insulator layer 514-1, and the second crystalline insulator layer 514-2 is nested within the amorphous layer 516. The insulator region and its component layers are generally similar to the insulator regions 120 and 320 and include the crystalline insulator 104 and amorphous insulator 106 described above. Unlike the insulator region 120, the layers of the insulator region 320 are not planar, but instead conform to the shape of the first electrode layer 512-1. In other embodiments, the insulator region may include a single layer of the crystalline insulator 104, as described with respect to FIG. 2.

A second electrode layer 512-2 is deposited over the insulator region, and in particular, over the second crystalline insulator layer 514-2. The second electrode layer 512-2 includes the electrode material 102 described above. In this embodiment, the second electrode layer 512-2, which is nested within the second crystalline insulator layer 514-2, completely fills an opening within the second crystalline insulator layer 514-2, rather than having a further opening within the second electrode layer 512-2 (e.g., as in the example of FIG. 3). In alternate embodiments, a further layer of dielectric is nested within the second electrode layer 512-2, as in FIG. 3.

The capacitor 520 may additionally include one or more template layers and/or seed layers, as described with respect to FIG. 1. Each of the layers 512, 514, and 516 may have thicknesses similar to the thicknesses of the layers 112, 114, and 116, respectively, as described with respect to FIG. 1.

Although not specifically shown in FIG. 5, the memory cell 500 may further include a bitline to transfer the memory state and coupled to the one of the S/D regions 504 to which the capacitor 520 is not coupled (e.g., to the S/D region 504-2, for the illustration of FIG. 5). Such a bitline can be connected to a sense amplifier and a bitline driver which may, e.g., be provided in a memory peripheral circuit associated with a memory array in which the memory cell 500 may be included. Furthermore, although also not specifically shown in FIG. 5, the memory cell 500 may further include a wordline, coupled to the gate terminal of the transistor, e.g., coupled to the gate stack 508, to supply a gate signal. The transistor may be configured to control transfer of a memory state of the memory cell 500 between the bitline and the storage node or the capacitor 520 in response to the gate signal. The capacitor 520, and in particular, the second electrode layer 512-2 of the capacitor 520, may be coupled to a plateline, as shown in FIG. 4.

### Example devices

The capacitors with crystalline and amorphous insulator layers disclosed herein may be included in any suitable electronic device. FIGS. 6-9 illustrate various examples of apparatuses that may include the one or more capacitors disclosed herein.

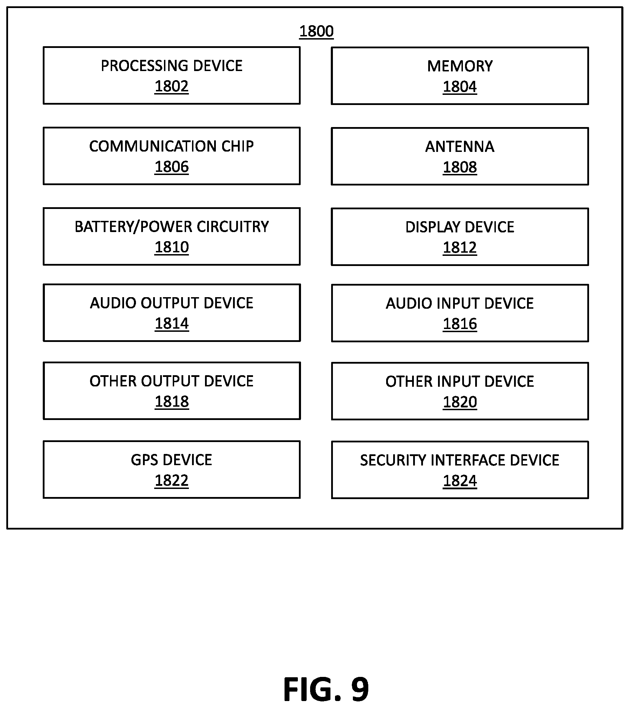

FIG. 6A and 6B are top views of a wafer and dies that include one or more IC structures including one or more capacitors with crystalline and amorphous insulator layers in accordance with any of the embodiments disclosed herein. The wafer 1500 may be composed of semiconductor material and may include one or more dies 1502 having IC structures formed on a surface of the wafer 1500. Each of the dies 1502 may be a repeating unit of a semiconductor product that includes any suitable IC structure (e.g., the IC structures as shown in any of FIGS. 1-5, or any further embodiments of the IC structures described herein). After the fabrication of the semiconductor product is complete (e.g., after manufacture of one or more IC structures with one or more of the transistors as described herein, included in a particular electronic component, e.g., in a transistor or in a memory device), the wafer 1500 may undergo a singulation process in which each of the dies 1502 is separated from one another to provide discrete "chips" of the semiconductor product. In particular, devices that include one or more of the transistors as disclosed herein may take the form of the wafer 1500 (e.g., not singulated) or the form of the die 1502 (e.g., singulated). The die 1502 may include one or more transistors (e.g., one or more of the transistors 1640 of FIG. 7, discussed below) and/or supporting circuitry to route electrical signals to the transistors, as well as any other IC components (e.g., one or more of the non-planar transistors described herein). In some embodiments, the wafer 1500 or the die 1502 may include a memory device (e.g., an SRAM device), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 9) or other logic that is configured to store information in the memory devices or execute instructions stored in the memory array.

FIG. 7 is a cross-sectional side view of an IC device 1600 that may include one or more capacitors with crystalline and amorphous insulator layers in accordance with any of the embodiments disclosed herein. The IC device 1600 may be formed on a substrate 1602 (e.g., the wafer 1500 of FIG. 6A) and may be included in a die (e.g., the die 1502 of FIG. 6B). The substrate 1602 may be any substrate as described herein. The substrate 1602 may be part of a singulated die (e.g., the dies 1502 of FIG. 6B) or a wafer (e.g., the wafer 1500 of FIG. 6A).

The IC device 1600 may include one or more device layers 1604 disposed on the substrate 1602. The device layer 1604 may include features of one or more transistors 1640 (e.g., metal-oxide-semiconductor field-effect transistors (MOSFETs)) formed on the substrate 1602. The device layer 1604 may include, for example, one or more source and/or drain (S/D) regions 1620, a gate 1622 to control current flow in the transistors 1640 between the S/D regions 1620, and one or more S/D contacts 1624 to route electrical signals to/from the S/D regions 1620. The transistors 1640 may include additional features not depicted for the sake of clarity, such as device isolation regions, gate contacts, and the like. The transistors 1640 are not limited to the type and configuration depicted in FIG. 7 and may include a wide variety of other types and configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon and nanowire transistors.

Each transistor 1640 may include a gate 1622 formed of at least two layers, a gate electrode layer and a gate dielectric layer.

The gate electrode layer may be formed on the gate interconnect support layer and may consist of at least one P-type workfunction metal or N-type workfunction metal, depending on whether the transistor is to be a PMOS or an NMOS transistor, respectively. In some implementations, the gate electrode layer may consist of a stack of two or more metal layers, where one or more metal layers are workfunction metal layers and at least one metal layer is a fill metal layer. Further metal layers may be included for other purposes, such as a barrier layer or/and an adhesion layer.

For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 electron Volts (eV) and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, aluminum carbide, tungsten, tungsten carbide. An N-type metal layer will enable the formation of an NMOS gate electrode with a workfunction that is between about 3.9 eV and about 4.2 eV.

In some embodiments, when viewed as a cross-section of the transistor 1640 along the source-channel-drain direction, the gate electrode may be formed as a U-shaped structure that includes a bottom portion substantially parallel to the surface of the substrate and two sidewall portions that are substantially perpendicular to the top surface of the substrate. In other embodiments, at least one of the metal layers that form the gate electrode may simply be a planar layer that is substantially parallel to the top surface of the substrate and does not include sidewall portions substantially perpendicular to the top surface of the substrate. In other embodiments, the gate electrode may be implemented as a combination of U-shaped structures and planar, non-U-shaped structures. For example, the gate electrode may be implemented as one or more U-shaped metal layers formed atop one or more planar, non-U-shaped layers. In some embodiments, the gate electrode may consist of a V-shaped structure (e.g., when a fin of a FinFET transistor does not have a "flat" upper surface, but instead has a rounded peak).

Generally, the gate dielectric layer of a transistor 1640 may include one layer or a stack of layers, and the one or more layers may include silicon oxide, silicon dioxide, and/or a high-k dielectric material. The high-k dielectric material included in the gate dielectric layer of the transistor 1640 may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

The IC device 1600 may include one or more capacitors with crystalline and amorphous insulator layers at any suitable location in the IC device 1600.

The S/D regions 1620 may be formed within the substrate 1602 adjacent to the gate 1622 of each transistor 1640, using any suitable processes known in the art. For example, the S/D regions 1620 may be formed using either an implantation/diffusion process or a deposition process. In the former process, dopants such as boron, aluminum, antimony, phosphorous, or arsenic may be ion-implanted into the substrate 1602 to form the S/D regions 1620. An annealing process that activates the dopants and causes them to diffuse farther into the substrate 1602 may follow the ion implantation process. In the latter process, an epitaxial deposition process may provide material that is used to fabricate the S/D regions 1620. In some implementations, the S/D regions 1620 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1620 may be formed using one or more alternate semiconductor materials such as germanium or a group III-V material or alloy. In further embodiments, one or more layers of metal and/or metal alloys may be used to form the S/D regions 1620. In some embodiments, an etch process may be performed before the epitaxial deposition to create recesses in the substrate 1602 in which the material for the S/D regions 1620 is deposited.

Electrical signals, such as power and/or input/output (I/O) signals, may be routed to and/or from the transistors 1640 of the device layer 1604 through one or more interconnect layers disposed on the device layer 1604 (illustrated in FIG. 7 as interconnect layers 1606-1610). For example, electrically conductive features of the device layer 1604 (e.g., the gate 1622 and the S/D contacts 1624) may be electrically coupled with the interconnect structures 1628 of the interconnect layers 1606-1610. The one or more interconnect layers 1606-1610 may form an ILD stack 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 7). Although a particular number of interconnect layers 1606-1610 is depicted in FIG. 7, embodiments of the present disclosure include IC devices having more or fewer interconnect layers than depicted.

In some embodiments, the interconnect structures 1628 may include trench contact structures 1628a (sometimes referred to as "lines") and/or via structures 1628b (sometimes referred to as "holes") filled with an electrically conductive material such as a metal. The trench contact structures 1628a may be arranged to route electrical signals in a direction of a plane that is substantially parallel with a surface of the substrate 1602 upon which the device layer 1604 is formed. For example, the trench contact structures 1628a may route electrical signals in a direction in and out of the page from the perspective of FIG. 7. The via structures 1628b may be arranged to route electrical signals in a direction of a plane that is substantially perpendicular to the surface of the substrate 1602 upon which the device layer 1604 is formed. In some embodiments, the via structures 1628b may electrically couple trench contact structures 1628a of different interconnect layers 1606-1610 together.

The interconnect layers 1606-1610 may include a dielectric material 1626 disposed between the interconnect structures 1628, as shown in FIG. 7. The dielectric material 1626 may take the form of any of the embodiments of the dielectric material provided between the interconnects of the IC structures disclosed herein.

In some embodiments, the dielectric material 1626 disposed between the interconnect structures 1628 in different ones of the interconnect layers 1606-1610 may have different compositions. In other embodiments, the composition of the dielectric material 1626 between different interconnect layers 1606-1610 may be the same.

A first interconnect layer 1606 (referred to as Metal 1 or "M1") may be formed directly on the device layer 1604. In some embodiments, the first interconnect layer 1606 may include trench contact structures 1628a and/or via structures 1628b, as shown. The trench contact structures 1628a of the first interconnect layer 1606 may be coupled with contacts (e.g., the S/D contacts 1624) of the device layer 1604.

A second interconnect layer 1608 (referred to as Metal 2 or "M2") may be formed directly on the first interconnect layer 1606. In some embodiments, the second interconnect layer 1608 may include via structures 1628b to couple the trench contact structures 1628a of the second interconnect layer 1608 with the trench contact structures 1628a of the first interconnect layer 1606. Although the trench contact structures 1628a and the via structures 1628b are structurally delineated with a line within each interconnect layer (e.g., within the second interconnect layer 1608) for the sake of clarity, the trench contact structures 1628a and the via structures 1628b may be structurally and/or materially contiguous (e.g., simultaneously filled during a dual-damascene process) in some embodiments.

A third interconnect layer 1610 (referred to as Metal 3 or "M3") (and additional interconnect layers, as desired) may be formed in succession on the second interconnect layer 1608 according to similar techniques and configurations described in connection with the second interconnect layer 1608 or the first interconnect layer 1606.

The IC device 1600 may include a solder resist material 1634 (e.g., polyimide or similar material) and one or more bond pads 1636 formed on the interconnect layers 1606-1610. The bond pads 1636 may be electrically coupled with the interconnect structures 1628 and configured to route the electrical signals of the transistor(s) 1640 to other external devices. For example, solder bonds may be formed on the one or more bond pads 1636 to mechanically and/or electrically couple a chip including the IC device 1600 with another component (e.g., a circuit board). The IC device 1600 may have other alternative configurations to route the electrical signals from the interconnect layers 1606-1610 than depicted in other embodiments. For example, the bond pads 1636 may be replaced by or may further include other analogous features (e.g., posts) that route the electrical signals to external components.

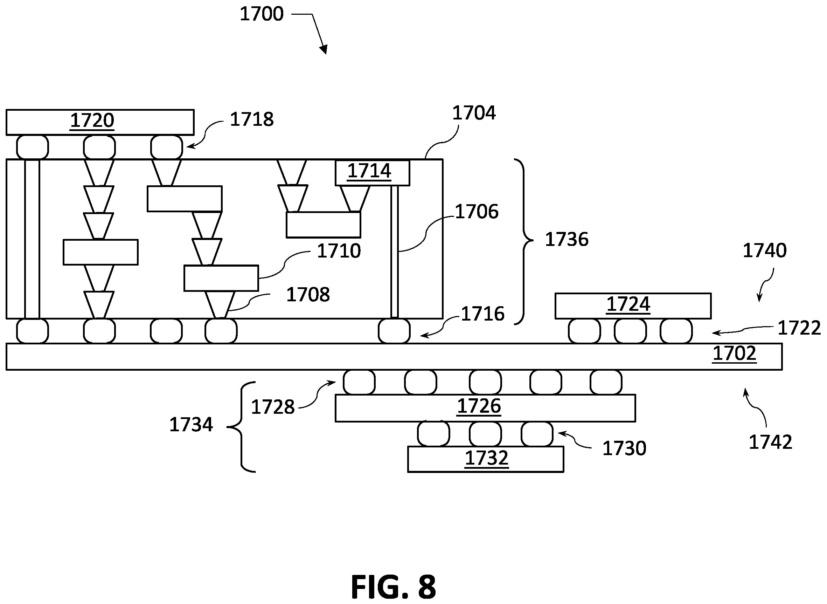

FIG. 8 is a cross-sectional side view of an IC device assembly 1700 that may include components having or being associated with (e.g., being electrically connected by means of) one or more capacitors with crystalline and amorphous insulator layers in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. In particular, any suitable ones of the components of the IC device assembly 1700 may include one or more of the non-planar transistors disclosed herein.

In some embodiments, the circuit board 1702 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 8 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702 and may include solder balls (as shown in FIG. 8), male and female portions of a socket, an adhesive, an underfill material, and/or any other suitable electrical and/or mechanical coupling structure.

The package-on-interposer structure 1736 may include an IC package 1720 coupled to an interposer 1704 by coupling components 1718. The coupling components 1718 may take any suitable form for the application, such as the forms discussed above with reference to the coupling components 1716. Although a single IC package 1720 is shown in FIG. 8, multiple IC packages may be coupled to the interposer 1704; indeed, additional interposers may be coupled to the interposer 1704. The interposer 1704 may provide an intervening substrate used to bridge the circuit board 1702 and the IC package 1720. The IC package 1720 may be or include, for example, a die (the die 1502 of FIG. 6B), an IC device (e.g., the IC device 1600 of FIG. 7), or any other suitable component. In some embodiments, the IC package 1720 may include one or more capacitors with crystalline and amorphous insulator layers, as described herein. Generally, the interposer 1704 may spread a connection to a wider pitch or reroute a connection to a different connection. For example, the interposer 1704 may couple the IC package 1720 (e.g., a die) to a ball grid array (BGA) of the coupling components 1716 for coupling to the circuit board 1702. In the embodiment illustrated in FIG. 8, the IC package 1720 and the circuit board 1702 are attached to opposing sides of the interposer 1704; in other embodiments, the IC package 1720 and the circuit board 1702 may be attached to a same side of the interposer 1704. In some embodiments, three or more components may be interconnected by way of the interposer 1704.

The interposer 1704 may be formed of an epoxy resin, a fiberglass-reinforced epoxy resin, a ceramic material, or a polymer material such as polyimide. In some implementations, the interposer 1704 may be formed of alternate rigid or flexible materials that may include the same materials described above for use in a semiconductor substrate, such as silicon, germanium, and other group III-V and group IV materials. The interposer 1704 may include metal interconnects 1708 and vias 1710, including but not limited to TSVs 1706. The interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency (RF) devices, power amplifiers, power management devices, antennas, arrays, sensors, and microelectromechanical systems (MEMS) devices may also be formed on the interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 8 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 9 is a block diagram of an example computing device 1800 that may include one or more capacitors with crystalline and amorphous insulator layers in accordance with any of the embodiments disclosed herein. For example, any suitable ones of the components of the computing device 1800 may include a die (e.g., the die 1502 (FIG. 6B)) having one or more capacitors with crystalline and amorphous insulator layers. Any one or more of the components of the computing device 1800 may include, or be included in, an IC device 1600 (FIG. 7). Any one or more of the components of the computing device 1800 may include, or be included in, an IC device assembly 1700 (FIG. 8).

A number of components are illustrated in FIG. 9 as included in the computing device 1800, but any one or more of these components may be omitted or duplicated, as suitable for the application. In some embodiments, some or all of the components included in the computing device 1800 may be attached to one or more motherboards. In some embodiments, some or all of these components are fabricated onto a single system-on-a-chip (SoC) die.

Additionally, in various embodiments, the computing device 1800 may not include one or more of the components illustrated in FIG. 9, but the computing device 1800 may include interface circuitry for coupling to the one or more components. For example, the computing device 1800 may not include a display device 1812, but may include display device interface circuitry (e.g., a connector and driver circuitry) to which a display device 1812 may be coupled. In another set of examples, the computing device 1800 may not include an audio input device 1816 or an audio output device 1814, but may include audio input or output device interface circuitry (e.g., connectors and supporting circuitry) to which an audio input device 1816 or audio output device 1814 may be coupled.

The computing device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The computing device 1800 may include a memory 1804, which may itself include one or more memory devices such as volatile memory (e.g., dynamic random access memory (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic random access memory (eDRAM) or spin transfer torque magnetic random-access memory (STT-MRAM).

In some embodiments, the computing device 1800 may include a communication chip 1806 (e.g., one or more communication chips). For example, the communication chip 1806 may be configured for managing wireless communications for the transfer of data to and from the computing device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1806 may implement any of a number of wireless standards or protocols, including but not limited to Institute for Electrical and Electronic Engineers (IEEE) standards including Wi-Fi (IEEE 1402.11 family), IEEE 1402.18 standards (e.g., IEEE 1402.18-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 1402.18 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 1402.18 standards. The communication chip 1806 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1806 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1806 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1806 may operate in accordance with other wireless protocols in other embodiments. The computing device 1800 may include an antenna 1808 to facilitate wireless communications and/or to receive other wireless communications (such as AM or FM radio transmissions).

In some embodiments, the communication chip 1806 may manage wired communications, such as electrical, optical, or any other suitable communication protocols (e.g., the Ethernet). As noted above, the communication chip 1806 may include multiple communication chips. For instance, a first communication chip 1806 may be dedicated to shorter-range wireless communications such as Wi-Fi or Bluetooth, and a second communication chip 1806 may be dedicated to longer-range wireless communications such as GPS, EDGE, GPRS, CDMA, WiMAX, LTE, EV-DO, or others. In some embodiments, a first communication chip 1806 may be dedicated to wireless communications, and a second communication chip 1806 may be dedicated to wired communications.

The computing device 1800 may include a battery/power circuitry 1810. The battery/power circuitry 1810 may include one or more energy storage devices (e.g., batteries or capacitors) and/or circuitry for coupling components of the computing device 1800 to an energy source separate from the computing device 1800 (e.g., AC line power).

The computing device 1800 may include a display device 1812 (or corresponding interface circuitry, as discussed above). The display device 1812 may include any visual indicators, such as a heads-up display, a computer monitor, a projector, a touchscreen display, a liquid crystal display (LCD), a light-emitting diode display, or a flat panel display, for example.

The computing device 1800 may include an audio output device 1814 (or corresponding interface circuitry, as discussed above). The audio output device 1814 may include any device that generates an audible indicator, such as speakers, headsets, or earbuds, for example.

The computing device 1800 may include an audio input device 1816 (or corresponding interface circuitry, as discussed above). The audio input device 1816 may include any device that generates a signal representative of a sound, such as microphones, microphone arrays, or digital instruments (e.g., instruments having a musical instrument digital interface (MIDI) output).

The computing device 1800 may include another output device 1818 (or corresponding interface circuitry, as discussed above). Examples of the other output device 1818 may include an audio codec, a video codec, a printer, a wired or wireless transmitter for providing information to other devices, or an additional storage device.

The computing device 1800 may include another input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 1800 may include a global positioning system (GPS) device 1822 (or corresponding interface circuitry, as discussed above). The GPS device 1822 may be in communication with a satellite-based system and may receive a location of the computing device 1800, as known in the art.

The computing device 1800 may include a security interface device 1824. The security interface device 1824 may include any device that provides security features for the computing device 1800 or for any individual components therein (e.g., for the processing device 1802 or for the memory 1804). Examples of security features may include authorization, access to digital certificates, access to items in keychains, etc. Examples of the security interface device 1824 may include a software firewall, a hardware firewall, an antivirus, a content filtering device, or an intrusion detection device.

The computing device 1800 may have any desired form factor, such as a hand-held or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 1800 may be any other electronic device that processes data.

### Select examples

The following paragraphs provide various examples of the embodiments disclosed herein.

Example 1 provides a device including a first electrode layer; a second electrode layer; an amorphous layer between the first electrode layer and the second electrode layer, the amorphous layer including oxygen; a first crystalline layer between the first electrode layer and the amorphous layer, the first crystalline layer including a crystalline insulator; and a second crystalline layer between the second electrode layer and the amorphous layer.

Example 2 provides the device of example 1, where the second crystalline layer includes the crystalline insulator.

Example 3 provides the device of example 1 or 2, where the crystalline insulator includes oxygen and titanium.

Example 4 provides the device of example 3, where the crystalline insulator is rutile.

Example 5 provides the device of example 3, where the crystalline insulator further includes at least one of barium and strontium.

Example 6 provides the device of example 1 or 2, where the crystalline insulator has a perovskite crystal structure.

Example 7 provides the device of example 1, where the crystalline insulator includes oxygen, lanthanum, and aluminum.

Example 8 provides the device of example 1, where the crystalline insulator includes oxygen, strontium, and titanium.

Example 9 provides the device of any of examples 1-8, where the amorphous layer further includes hafnium.

Example 10 provides the device of any of examples 1-8, where the amorphous layer further includes zirconium.

Example 11 provides the device of any of examples 1-8, where the amorphous layer further includes titanium.

Example 12 provides the device of example 11, where the amorphous layer further includes strontium.

Example 13 provides the device of example 11 or 12, where the amorphous layer further includes strontium.

Example 14 provides the device of any of examples 1-13, where the amorphous layer has a thickness between the first crystalline layer and the second crystalline layer of less than 5 nanometers.

Example 15 provides the device of any of examples 1-14, where a distance between the first electrode layer and the second electrode layer is less than 20 nanometers.

Example 16 provides the device of any of examples 1-15, where the first electrode layer includes ruthenium.

Example 17 provides the device of any of examples 1-15, where the first electrode layer includes titanium and nitrogen.

Example 18 provides the device of any of examples 1-15, where the first electrode layer includes oxygen and at least one of iridium and molybdenum.

Example 19 provides the device of any of examples 1-15, where the first electrode layer includes at least one of rhenium, tungsten, and molybdenum.

Example 20 provides a device including an access transistor; and a capacitor coupled to the access transistor, the capacitor including a pair of electrodes; a first insulator layer between the pair of electrodes, the first insulator layer including oxygen and the first insulator layer having a crystalline structure; and a second insulator layer between the pair of electrodes, the second insulator layer including oxygen and the second insulator layer having an amorphous structure.

Example 21 provides the device of example 20, the capacitor further including a third insulator layer having a crystalline structure, where the second insulator layer is between the first insulator layer and the third insulator layer.

Example 22 provides the device of example 20 or 21, where the first insulator layer further includes titanium.

Example 23 provides the device of any of examples 20-22, where the first insulator layer has a tetragonal crystal structure.

Example 24 provides the device of any of examples 20-22, where the first insulator layer has a perovskite crystal structure.

Example 25 provides the device of any of examples 20-24, where the pair of electrodes includes a first electrode and a second electrode, and at least a portion of the second electrode is nested within the first electrode.

Example 26 provides an assembly including an integrated circuit; and a decoupling capacitor coupled to the integrated circuit, the decoupling capacitor including a first crystalline layer, a second crystalline layer, and an amorphous layer between the first crystalline layer and the second crystalline layer, where the first crystalline layer, the second crystalline layer, and the amorphous layer are insulators.

Example 27 provides the assembly of example 26, where the assembly includes a device layer, where transistors of the integrated circuit are within the device layer; and a backside layer below the device layer, where the decoupling capacitor is formed within the backside layer.

Example 28 provides the assembly of example 27, where the device layer and the backside layer are layers of a die.

Example 29 provides the assembly of example 26, where the integrated circuit is on a die, and the decoupling capacitor is separate from the die.

Example 30 provides the assembly of any of examples 26-29, the decoupling capacitor extends into a plurality of openings in a dielectric layer, where, in one of the openings, a portion of the second crystalline layer is nested within a portion of the first crystalline layer.

Example 31 provides the assembly of any of examples 26-30, where the first crystalline layer has a first grain size, the second crystalline layer has a second grain size smaller than the first grain size.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. A device comprising:
a first electrode layer;
a second electrode layer;
an amorphous layer between the first electrode layer and the second electrode layer, the amorphous layer comprising oxygen;
a first crystalline layer between the first electrode layer and the amorphous layer, the first crystalline layer comprising a crystalline insulator; and
a second crystalline layer between the second electrode layer and the amorphous layer.

2. The device of claim 1, wherein the second crystalline layer comprises the crystalline insulator.

3. The device of claim 1 or 2, wherein the crystalline insulator comprises oxygen and titanium.

4. The device of claim 3, wherein the crystalline insulator is rutile.

5. The device of claim 3, wherein the crystalline insulator further comprises at least one of barium and strontium.

6. The device of claim 1 or 2, wherein the crystalline insulator has a perovskite crystal structure.

7. The device of claim 1, wherein the crystalline insulator comprises oxygen, lanthanum, and aluminum.

8. The device of claim 1, wherein the crystalline insulator comprises oxygen, strontium, and titanium.

9. The device of any of claims 1-8, wherein the amorphous layer further includes one of hafnium, zirconium, titanium, and strontium.

10. The device of any of claims 1-9, wherein the amorphous layer has a thickness between the first crystalline layer and the second crystalline layer of less than 5 nanometers.

11. The device of any of claims 1-10, wherein a distance between the first electrode layer and the second electrode layer is less than 20 nanometers.

12. A device comprising:
an access transistor; and
a capacitor coupled to the access transistor, the capacitor comprising:
a pair of electrodes;
a first insulator layer between the pair of electrodes, the first insulator layer comprising oxygen and the first insulator layer having a crystalline structure; and
a second insulator layer between the pair of electrodes, the second insulator layer comprising oxygen and the second insulator layer having an amorphous structure.

13. The device of claim 12, the capacitor further comprising a third insulator layer having a crystalline structure, wherein the second insulator layer is between the first insulator layer and the third insulator layer.

14. The device of claim 12 or 13, wherein the first insulator layer further comprises titanium.

15. The device of any of claims 12-14, wherein the pair of electrodes comprises a first electrode and a second electrode, and at least a portion of the second electrode is nested within the first electrode.
